# FASCICULE DE BREVET EUROPEEN

(11) **EP 1 707 531 B1**
(45) Date de publication et mention de la délivrance du brevet: **07.05.2008**
(21) Numéro de dépôt: 06354008.2
(22) Date de dépôt: 08.03.2006
(51) Int. Cl.: B81C 1/00

(54) **Procédé de fabrication de micro-canaux enterrés et micro-dispotif comprenant de tels micro-canaux**
Verfahren zum Fertigen von vergrabenen Mikrokanälen und Mikrovorrichtung mit solchen Mikrokanälen
Process for manufacturing of buried microchannels and micro-decive with such microchannels

(30) Priorité: 29.03.2005 FR 0503029
(43) Date de publication de la demande: 04.10.2006
(73) Titulaire: Commisariat à l'énergie Atomique, 75752 Paris 15ème (FR)
(72) Inventeur: Plissonnier, Marc, 38320 Eybens (FR); Fouillet, Yves, 38340 Voreppe (FR); Poupinet, Ludovic, 38360 Sassenage (FR); Laurent, Jean-Yves, 38420 Domene (FR)
(74) Mandataire: Hecké, Gérard

(56) Documents cités:
- DE-A1- 10 064 456
- US-A1- 2003 071 269

## Description

### Domaine technique de l'invention

L'invention concerne un procédé de fabrication d'au moins un micro-canal enterré sur un substrat.

L'invention concerne également un micro-dispositif comportant au moins un micro-canal destiné à transporter au moins un fluide.

### État de la technique

Dans de nombreux domaines tels que le domaine des analyses chimiques, biologiques, biochimiques et environnementales, le domaine médical ou le contrôle qualité, le développement des micro-technologies a permis de réaliser des micro-systèmes fluidiques formant des laboratoires sur puces ou "lab-on-chip". De tels laboratoires sur puces permettent de miniaturiser les volumes de liquide à analyser, tout en augmentant la vitesse et la sensibilité des mesures. Ces micro-systèmes comportent généralement des canaux destinés à permettre le transport et/ou des réactions chimiques ou biologiques de différents fluides.

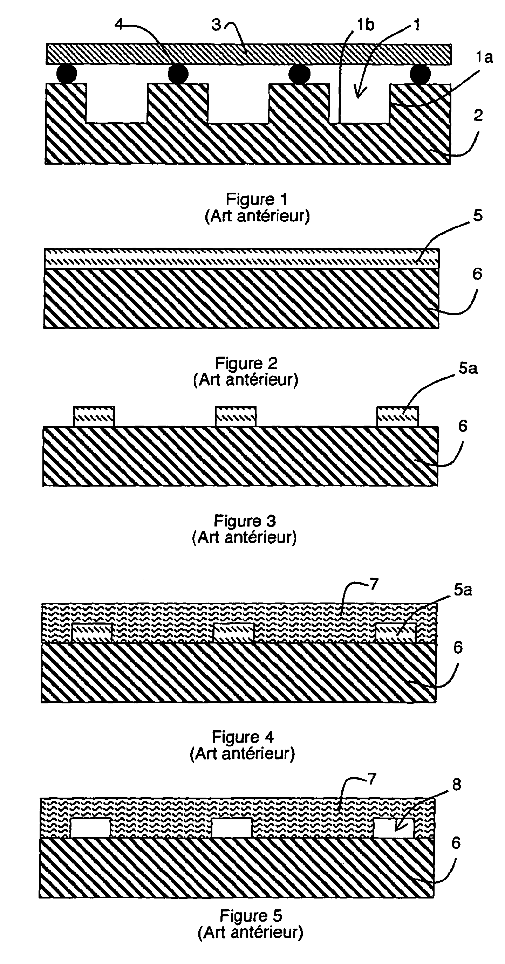

Comme représentée à la figure 1, une des techniques pour réaliser les canaux d'un micro-système fluidique consiste à structurer les parois latérales 1a et le fond 1 b de canaux 1 dans un substrat 2. Le substrat 2 est, en général, en silicium ou en polymère. Ainsi, lorsque le substrat 2 est en silicium, les parois 1 a et le fond 1 b sont généralement obtenus par des techniques issues de la micro-électronique, telles que la photolithographie ou la gravure tandis que, pour un substrat 2 en polymère, la formation des parois latérales 1 a et du fond 1 b des canaux 1 est obtenue par moulage. Pour éviter d'éventuelles contaminations, un capot de protection 3 est scellé par des joints d'étanchéité 4 sur le substrat 2 et il recouvre les canaux 1. De plus, les joints d'étanchéité 4 sont disposés entre deux canaux adjacents de manière à les isoler les uns des autres. La réalisation de canaux dans le substrat, par gravure, photolithographie ou moulage, ne permet, cependant, pas d'obtenir des canaux de très petites dimensions et notamment de dimensions nanométriques. De plus, il est difficile de contrôler efficacement l'étanchéité du capot de protection 3, ce qui peut poser des problèmes de contamination entre le milieu extérieur et les canaux et entre des canaux adjacents.

Une autre technique pour réaliser des canaux consiste à utiliser un matériau sacrificiel, c'est-à-dire pouvant être dissous par voie chimique. Ainsi, comme représenté aux figures 2 à 5, une couche mince 5 sacrificielle est déposée sur la surface libre d'un substrat 6 plan, avant d'être photolithographiée et gravée, de manière à former des zones structurées en relief 5a. Une couche épaisse 7 recouvre ensuite totalement la surface libre du substrat 6 et les zones en relief 5a (figure 4), enterrant, ainsi, les zones en relief 5a. Puis, chaque zone en relief 5a est dissoute, ce qui permet de libérer un espace 8 délimité par la couche épaisse 7 et le substrat 6. Chaque espace 8 forme, alors un micro-canal enterré, c'est-à-dire un conduit micro-fluidique muni généralement d'une entrée et d'une sortie. Une telle technique ne permet, cependant, pas d'obtenir des canaux de très petites dimensions. De plus, des canaux de forme complexe ne peuvent pas être réalisés avec cette technique, car, avec des canaux de forme complexe, des résidus de matériaux non dissous et potentiellement contaminants pour les fluides ne sont pas éliminés.

Enfin, les deux techniques décrites utilisent une étape de structuration, soit du substrat, soit d'une couche sacrificielle. Or, cette étape de structuration est relativement coûteuse.

Il a également été proposé de réaliser des canaux de dimensions nanométriques en utilisant des fils de silicium obtenus par dépôt chimique en phase vapeur (CVD), avec un diamètre de l'ordre de quelques nanomètres. Chaque fil de silicium est, ensuite, entouré d'oxyde de silicium obtenu par croissance par oxydation thermique. Le silicium du fil, gainé par l'oxyde de silicium, est ensuite éliminé par une solution chimique, ce qui libère un espace délimité par l'oxyde de silicium. Cette technique nécessite, cependant, une manipulation individuelle des fils de silicium. De plus, la longueur des fils de silicium, et donc des canaux, est relativement faible pour un dispositif micro-fluidique. Enfin, la connexion entre différents canaux formés à partir des nano-fils et entre un canal formé à partir d'un nano-fil et un canal obtenu par une autre technique n'est pas aisée.

Le document US2003/071269 décrit une méthode de fabrication de microcanaux scellés ou clos, disposés entre des premier et second substrats, respectivement transparent et opaque, en utilisant des ondes électromagnétiques. Le second substrat opaque est capable d'absorber et de propager les ondes électromagnétiques reçues à travers le premier substrat, ce qui provoque soit la fusion (dans le cas d'une diffusion thermique), soit l'évaporation (dans le cas d'une ablation) d'une petite partie de la surface du second substrat opaque, lorsque celui-ci atteint sa température de transition de phase. Ceci permet alors de créer un micro-canal, soit par ablation, vaporisation ou évaporation d'une portion du second substrat. Un tel microcanal forme alors un joint de fusion entre les premier et second substrats de manière à faire apparaître une liaison forte entre lesdits substrats.

Le document DE-A-10064456 décrit une méthode pour structurer, sans contact physique, un empilement déposé sur un substrat et comprenant une première couche diélectrique, des nanoparticules métalliques et une seconde couche diélectrique. La structuration est réalisée par l'intermédiaire d'un faisceau laser qui change localement la densité et la taille des particules métalliques. Cette méthode permet, ainsi, d'obtenir des pistes conductrices, par percolation desdites particules métalliques.

### Objet de l'invention

L'invention a pour but un procédé facile à mettre en oeuvre, peu coûteux et permettant d'obtenir des canaux enterrés de très petites dimensions, de tout type de géométrie, facilement connectables entre eux et parfaitement étanches à tout type de contamination.

Selon l'invention, ce but est atteint par le fait ce que le procédé comporte au moins les étapes successives suivantes :
- la formation, à la surface du substrat, d'un empilement d'une couche mince apte à libérer du gaz sous l'action d'un échauffement et d'une couche mince absorbante capable de se déformer localement,
- l'application locale d'un rayonnement optique sur l'empilement de manière à former, à l'interface entre les deux couches minces, par échauffement local de la couche mince apte à libérer du gaz, une bulle de gaz déformant la couche mince absorbante
- et le déplacement du rayonnement optique selon une direction prédéterminée de manière à prolonger la déformation de la couche mince absorbante selon ladite direction et former le micro-canal enterré.

Selon un développement de l'invention, la couche mince apte à libérer du gaz est en SiCₓO_{y}:H, avantageusement avec x compris entre 0,8 et 1,4 et y compris entre 1,2 et 1,4.

Plus particulièrement, la couche mince en SiCₓO_{y}:H peut être obtenue par dépôt chimique en phase vapeur, à l'aide d'un précurseur choisi parmi les organo-silanes.

Selon un mode particulier de réalisation, la formation du micro-canal enterré est suivie d'une étape supplémentaire pendant laquelle un rayonnement optique est appliqué localement sur l'empilement de manière à percer la couche mince absorbante déformée et à former, dans le micro-canal enterré, une ouverture.

L'invention a également pour but un micro-dispositif comportant au moins un micro-canal destiné à transporter au moins un fluide, présentant de très petites dimensions, de tout type de géométrie et parfaitement étanche à tout type de contamination.

Selon l'invention, ce but est atteint par le fait que le micro-canal d'un tel micro-dispositif est un micro-canal enterré sur un substrat mis en oeuvre par un procédé de fabrication tel que décrit ci-dessus.

Selon un développement de l'invention, le micro-canal est destiné à transporter un fluide contenant des éléments chimiques ou biologiques.

Selon un autre développement de l'invention, le micro-dispositif constitue une micro-pile à combustible comportant au moins :
- un empilement constitué par des première et seconde électrodes entre lesquelles est disposée une membrane constituée par un polymère conducteur ionique
- et au moins une série de micro-canaux enterrés, destinés à alimenter ladite micro-pile en fluide réactif et munis d'au moins une ouverture pour permettre l'alimentation en fluide réactif.

Une telle micro-pile à combustible présente l'avantage d'être compacte et d'avoir des performances globales améliorées par rapport aux micro-piles à combustible selon l'art antérieur.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 représente, schématiquement, en coupe, un mode de réalisation de micro-canaux dans un substrat, selon l'art antérieur.
Les figures 2 à 5 représentent schématiquement, en coupe, un mode de fabrication de micro-canaux enterrés sur un substrat, selon l'art antérieur.
Les figures 6 à 9 représentent schématiquement, en coupe, différentes étapes de réalisation de micro-canaux enterrés sur un substrat, selon l'invention.
La figure 10 est une vue en perspective de l'empilement représenté en coupe à la figure 9 et comportant des micro-canaux obtenus selon l'invention.
La figure 11 représente, en coupe, une étape supplémentaire de réalisation de micro-canaux enterrés sur une structure selon la figure 10.
La figure 12 représente la variation de la hauteur d'une bulle de gaz en fonction de la puissance d'un rayonnement optique appliqué et en fonction de l'épaisseur d'une couche en SiCₓO_{y}:H permettant la formation de la bulle de gaz.
Les figures 13 à 16 représentent, schématiquement, en coupe, les différentes étapes de réalisation d'une micro-pile à combustible comprenant des micro-canaux obtenus selon l'invention.

### Description de modes particuliers de réalisation

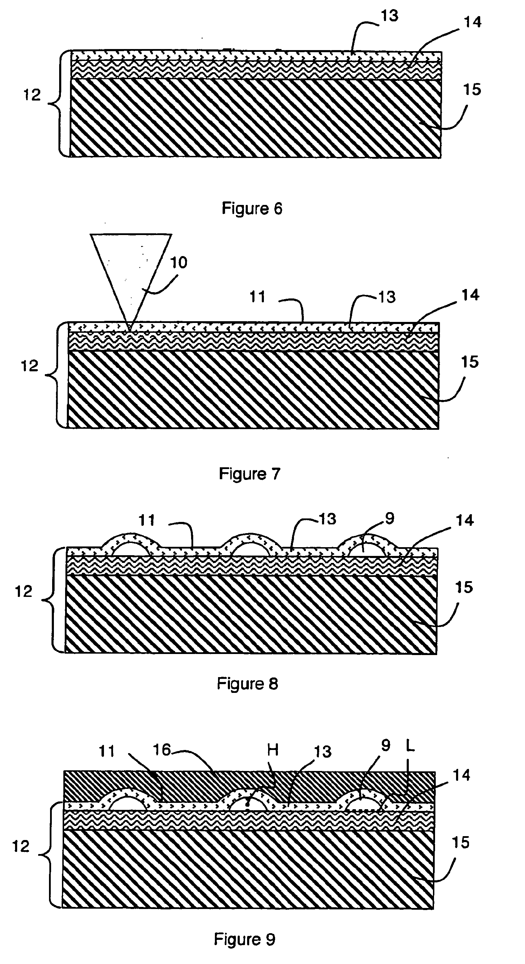

Comme illustré dans un mode particulier de réalisation représenté aux figures 6 à 10, des micro-canaux 9 enterrés sont réalisés en appliquant et en déplaçant, selon une direction prédéterminée un rayonnement optique 10, tel qu'un faisceau laser focalisé, sur une surface libre 11 d'un empilement 12 comprenant successivement :
- une couche mince 13 déformable et apte à absorber au moins une partie du rayonnement optique 10 de manière à créer un échauffement
- une couche mince 14 constituée par un matériau apte à libérer localement du gaz, sous l'action dudit échauffement
- et un substrat 15 de préférence plan.

Ainsi, à la figure 6, l'empilement 12 est formé en déposant préalablement, sur une surface libre du substrat 15, la couche mince 14, puis en la recouvrant par la couche mince déformable et absorbante 13. Puis, comme représenté à la figure 7, le rayonnement optique 10 est appliqué localement sur l'empilement 12, depuis la surface libre de la couche mince absorbante 13 jusqu'à l'intérieur de l'empilement. La surface libre de la couche mince absorbante 13 forme, alors, la surface libre 11 de l'empilement 12, destinée à recevoir le rayonnement optique 10.

Le rayonnement optique 10 est absorbé par l'empilement 12 afin de provoquer un échauffement local dans l'empilement et, plus particulièrement, dans la couche mince 14 apte à dégager du gaz. Cette absorption peut être réalisée, en particulier, par la couche mince 13, choisie pour son aptitude à absorber au moins une partie du rayonnement optique 10. La couche mince 13 est également appelée couche mince absorbante 13, capable de se déformer localement.

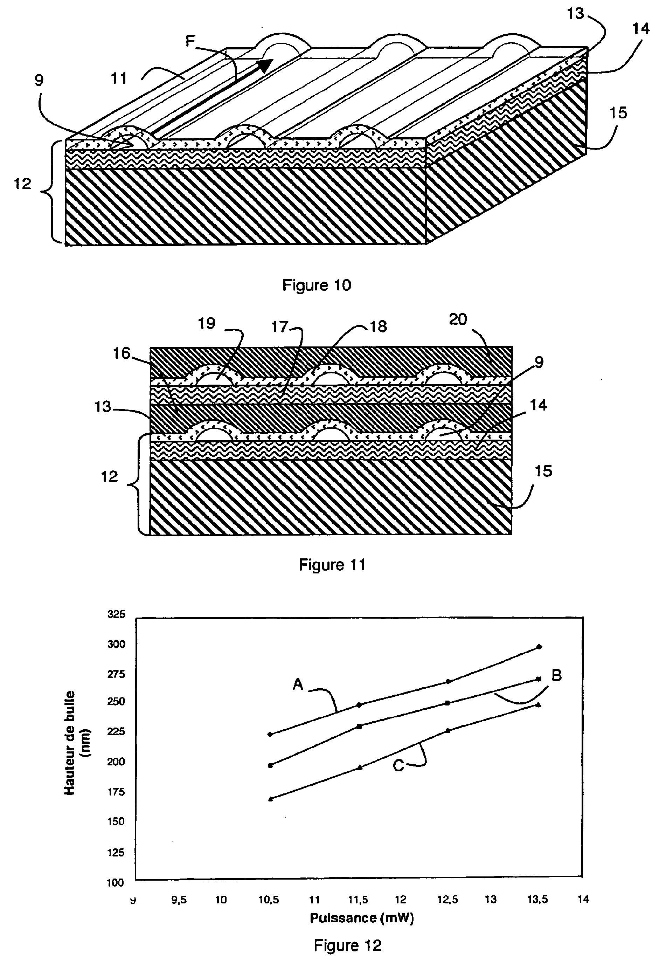

Sous l'action d'un échauffement local de la couche mince 14, une bulle de gaz se forme à l'interface entre les couches minces 13 et 14 et provoque, par action mécanique, une déformation locale de la couche mince absorbante 13. Le rayonnement optique 10 est, ensuite, déplacé selon une direction prédéterminée, de manière à prolonger, de manière continue, la formation de bulles de gaz, à l'interface entre les deux couches minces, selon la direction de déplacement. A la figure 10, la direction de déplacement du rayonnement optique 10 est représentée par la flèche F. Ce déplacement permet, alors, de prolonger la déformation de la couche absorbante 13. Comme illustré aux figures 8 à 10, la zone déformée de la couche absorbante 13 délimite alors, avec la surface de la couche mince 14 qui a libéré du gaz, un espace et l'ensemble forme un conduit ou un canal enterré 9.

L'invention n'est pas limitée à la réalisation d'un canal enterré sur un substrat. En effet, une pluralité de canaux enterrés peut être formée dans l'empilement, simultanément ou successivement. A titre d'exemple, plusieurs rayonnements optiques peuvent être appliqués et déplacés simultanément. Dans une variante de réalisation, le rayonnement optique 10, après avoir formé un premier canal enterré 9, peut être positionné à un autre emplacement, avant d'être à nouveau appliqué sur l'empilement et déplacé selon une seconde direction déterminée pour former un second canal enterré 9.

Ainsi, aux figures 8 et 10, l'empilement comporte trois canaux enterrés 9 formés, dans leur longueur, selon trois directions prédéterminées parallèles. Les directions prédéterminées peuvent aussi ne pas être parallèles de manière à ce que les canaux enterrés se croisent et forment un réseau.

Une fois les micro-canaux 9 formés, un rayonnement optique tel qu'un faisceau laser peut être appliqué une ou plusieurs fois sur la surface libre de la couche absorbante 13, au niveau des zones déformées, pour percer ladite couche absorbante 13. Cette opération permet de former, dans un micro-canal enterré 9, une ou plusieurs ouvertures qui peuvent être, par exemple l'entrée et/ou la sortie du canal. L'opération destinée à percer la couche absorbante 13 peut, par exemple, être réalisée soit en augmentant la puissance du rayonnement optique 10 utilisé pour former les micro-canaux 9, soit en prolongeant la durée d'exposition ou en répétant l'exposition du rayonnement optique 10 sur l'empilement 12.

Comme représenté à la figure 9, une fois les canaux 9 enterrés formés, une couche de protection 16 peut éventuellement être déposée sur la surface libre 11 de la couche mince absorbante 13, de manière à consolider les canaux 9 formés. La couche de protection 16 est, par exemple, en nitrure de silicium ou en oxyde de silicium et elle peut être déposée à la tournette ("Spin Coating") ou par dépôt chimique en phase vapeur (CVD), éventuellement assisté par plasma (PECVD). Elle permet d'obtenir un empilement 12 comportant deux surfaces libres planes. Lorsque les canaux 9 présentent une ou plusieurs ouvertures, la couche de protection 16 est, de préférence, elle-même percée à l'aplomb, c'est-à-dire en regard, de la ou des ouvertures des canaux

La hauteur H et la largeur L d'un canal 9 sont représentées sur la figure 9. Plus particulièrement, pour obtenir un micro-canal 9 ayant une hauteur H de 200nm, un faisceau laser focalisé est généralement utilisé, avec une densité de puissance variant entre 23mW/µm² et 32mW/µm² et la couche mince 14 a, généralement, une épaisseur comprise entre 10nm et 60nm. Par ailleurs, la longueur d'un canal 9 correspond à la distance parcourue par le rayonnement optique 10.

Dans une variante de réalisation représentée à la figure 11, les différentes étapes du procédé de fabrication des micro-canaux 9 peuvent être répétées sur la surface libre de la couche de protection 16. Ceci permet d'obtenir une structure comportant au moins deux séries superposées de micro-canaux. Ainsi, un empilement tel que celui représenté à la figure 10 et muni d'une première série de canaux 9 est successivement recouvert :
- d'une couche mince supplémentaire 17 constitué par un matériau apte à libérer localement du gaz,
- et d'une couche mince absorbante supplémentaire 18.

Après l'application et le déplacement d'un rayonnement optique à la surface libre de la couche mince absorbante supplémentaire 18, une seconde série de canaux 19 enterrés est formée. L'ensemble est ensuite recouvert d'une couche de protection 20 destinée à consolider la deuxième série de micro-canaux 19.

Le matériau apte à libérer du gaz et formant, aux figures 8 et 11, la ou les couches minces 14 et 17 est, choisi de manière à ce que sa composition chimique permette de dégager localement une quantité suffisante de gaz pour former une bulle, tout en conservant une tenue mécanique garantissant la stabilité de l'empilement. Le matériau apte à libérer du gaz est, plus particulièrement, à base de polysiloxane obtenu par dépôt chimique en phase vapeur (CVD), de préférence assisté par plasma (PECVD), à l'aide d'un précurseur choisi parmi les organo-silanes. Le matériau apte à libérer du gaz est, de préférence, un oxyde de silicium amorphe hydrogéné dopé par du carbone de type SiCₓO_{y}:H, avec, de préférence, x compris entre 0,8 et 1,4 et y compris entre 1,2 et 1,4. Plus particulièrement, pour former une couche en SiCₓO_{y}:H, le précurseur organo-silane est constitué par l'octaméthyltétrasiloxane cyclique (OMCTS) ou un de ses dérivés et il est mélangé avec de l'hélium. L'épaisseur des couches minces 14 et 17 est, de préférence, comprise entre 10nm et 60nm. De plus, pour obtenir un dégagement suffisant de gaz, les conditions de dépôt de SiCₓO_{y}:H sont, de préférence, choisies de manière à obtenir une couche mince en SiCₓO_{y}:H ayant une conformation ou une structure préservant partiellement la structure du précurseur OMCTS cyclique utilisé.

Le fait d'utiliser un oxyde de silicium amorphe hydrogéné dopé par du carbone pour former une couche mince destinée à générer du gaz présente également l'avantage d'obtenir un micro-canal ayant une paroi inférieure hydrophile. En effet, la surface de la zone ayant libérée du gaz sous l'action du rayonnement optique 10, forme la paroi inférieure ou un fond du micro-canal 9. Or, lorsque l'oxyde de silicium amorphe hydrogéné dopé par du carbone est chauffé par le rayonnement optique 10, il libère non seulement du gaz mais il devient également hydrophile, ce qui permet à une solution aqueuse de pouvoir pénétrer et éventuellement se déplacer dans le canal.

La ou les couches minces absorbantes 13 et 18 sont déformables, c'est-à-dire qu'elles sont capables de se déformer localement sous l'effet d'une action mécanique exercée sur ladite ou lesdites couche mince absorbante. Elles sont, par exemple, constituées par un composé choisi parmi un alliage de tellure et d'étain (SnTe), un alliage de tellure et de zinc (ZnTe). Elles ont, par exemple, une épaisseur de quelques dizaines de nanomètres.

A titre d'exemple, une couche mince 14 en SiCₓO_{y}:H, de 20nm d'épaisseur, est déposée sur un substrat en silicium ou en polycarbonate, par dépôt PECVD, en utilisant un plasma excité par une décharge capacitive à 13,56Mhz. Un générateur basse fréquence ou radiofréquence permet alors de réaliser une décharge plasma au voisinage du substrat et le précurseur OMCTS cyclique, mélangé avec de l'hélium, est injecté dans l'enceinte de dépôt, à pression réduite, par exemple à 0,2mBar. La densité de puissance plasma est, par exemple, de 0,81 W/cm et le débit de précurseur introduit dans l'enceinte est, par exemple, de 0,273cm³/min. Le matériau de la couche mince 14 déposée a, plus particulièrement, la formule suivante : SiC_{0,2}O_{0,3}H_{0,55}.

Une couche absorbante 13, en SnTe et de 20nm d'épaisseur est ensuite déposée sur la couche mince 14 puis elle est irradiée par un faisceau laser focalisé dont la densité de puissante est comprise entre 23mW/µm² et 32mW/µm². La source du faisceau laser est, par exemple, une diode laser focalisée avec un objectif de microscope. Le faisceau laser focalisé est, ensuite déplacé sur la surface libre de la couche mince absorbante 13. Une fois le ou les micro-canaux formés, une couche de protection, par exemple en SiO₂ ou en Si₃N₄ est éventuellement déposée sur la surface libre de la couche absorbante 13.

La quantité de gaz émise par la ou les couches minces aptes à générer du gaz dépend également de la densité de puissance du rayonnement optique 10. A titre d'illustration, sur la figure 12, les courbes A à C illustrent la variation de la hauteur d'une bulle de gaz réalisée dans un empilement tel que celui représenté à la figure 6, en fonction de la puissance du faisceau laser utilisé, pour des épaisseurs de couche mince 14 en SiCₓO_{y}H:, respectivement de 20, 40 et 60nm. La couche absorbante 13 déformable est en SnTe. On constate que la hauteur de la bulle de gaz générée augmente lorsque la puissance du faisceau laser augmente. Par ailleurs, la hauteur de la bulle de gaz et donc la hauteur H du canal 9 est maximale lorsque l'épaisseur de la couche mince 14 est de 20nm.

Le procédé de fabrication selon l'invention permet d'obtenir sur un substrat des micro-canaux enterrés, de très petites dimensions, susceptibles d'être contrôlées et relativement peu coûteux à réaliser. Un tel procédé est, plus particulièrement adapté à la réalisation de micro-dispositifs munis de micro-canaux destinés à transporter des fluides contenant, par exemple, des éléments chimiques ou biologiques tels que les micro-dispositifs fluidiques utilisés, par exemple, pour l'analyse chimique ou biologique. Plus particulièrement, il est possible, grâce à l'étroitesse du rayonnement optique utilisé, de réaliser des micro-canaux présentant une largeur L comprise entre 0,1µm et 2µm et une hauteur H comprise entre 0,06µm et 0,2µm. De plus, un empilement peut comporter une densité importante de canaux enterrés, il est très facile de les connecter entre eux et/ou avec des canaux réalisés par des techniques selon l'art antérieur. Les canaux étant enterrés, il n'y a, par ailleurs, pas de risque de contamination entre deux canaux indépendants. Par ailleurs, le rayonnement optique permettant de former les micro-canaux peut se déplacer selon une direction quelconque, ce qui permet d'obtenir tout type de micro-canaux et, plus particulièrement des micro-canaux non linéaires. Ceci est particulièrement intéressant pour réaliser des micro-systèmes d'analyse chimique ou biologique. Il est également possible de réaliser une colonne de chromatographie ou un réacteur biochimique nécessitant une grande surface d'interaction entre un solide et un liquide. Dans ce cas, il est possible de réaliser des micro-canaux se croisant, notamment pour former une sorte de labyrinthe.

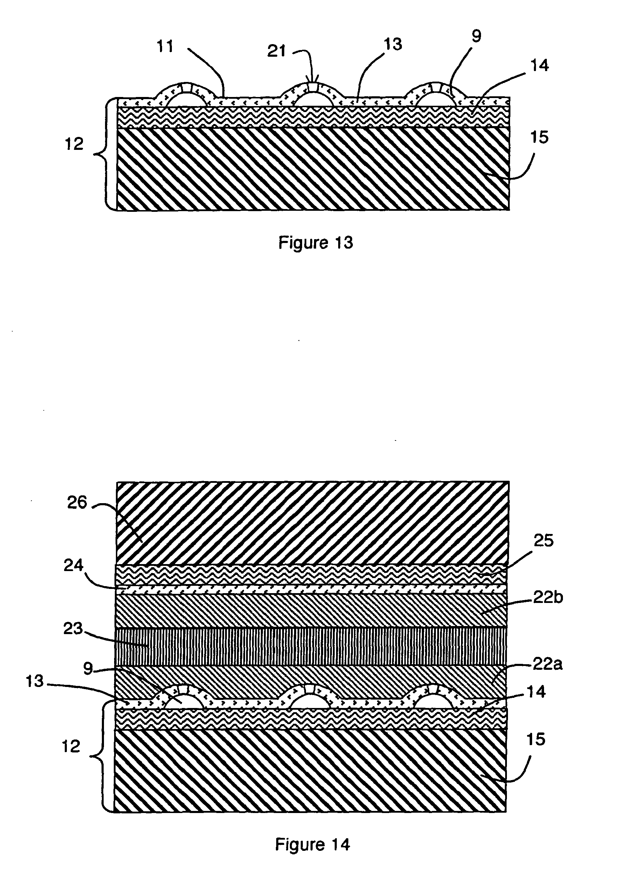

Comme représenté aux figures 13 à 16, le procédé de fabrication de micro-canaux enterrés peut également être utilisé dans la fabrication d'une micro-pile à combustible. Ainsi, un empilement contenant une série de micro-canaux enterrés tels que représenté à la figure 8 peut servir de base à la réalisation d'une pile à combustible. Une fois les micro-canaux 9 formés, un rayonnement optique tel qu'un faisceau laser peut être appliqué sur la surface libre de la couche absorbante 13 pour percer ladite couche absorbante 13. Cette opération permet de former, dans la couche absorbante 13, une ouverture 21. L'opération peut être répétée plusieurs fois de manière à former une succession d'ouvertures 21 localisées le long d'un micro-canal 9. Cette ouverture 21 peut aussi être prolongée sur toute la longueur d'un micro-canal 9, en déplaçant le faisceau laser.

Comme représenté à la figure 14, un empilement successif de couches minces, de type EME (Electrode-Membrane-Electode), est déposé sur la surface libre de la couche mince absorbante 13. L'empilement de type EME comporte des première et seconde électrodes 22a et 22b entre lesquelles est disposée une membrane 23 constituée par un polymère conducteur ionique. Le polymère de la membrane 23 est, par exemple, du Nafion® déposé par "Spin Coating" tandis que les première et seconde électrodes 22a et 22b sont, par exemple, de la poudre de carbone platiné, c'est-à-dire un catalyseur sous forme de poudre de carbone, mélange à des particules actives de platine. Les canaux 9 formés à l'interface de la couche mince absorbante 13 et de la couche mince 14 et muni d'ouvertures 21 forment, alors, une première série de micro-canaux d'alimentation en fluides réactifs de la première électrode 22a.

Puis, une couche mince absorbante supplémentaire 24, une couche mince supplémentaire 25 apte à générer du gaz et un substrat 26 rigide et transparent au rayonnement optique sont successivement disposés sur la surface libre de la seconde électrode 22b. La couche absorbante supplémentaire 25 est alors déformée, puis percée sous l'action d'un rayonnement optique provenant de la surface libre du substrat 26, de manière à former une seconde série de micro-canaux enterrés 27 munis d'ouvertures 28 se répétant sur toute la longueur des canaux. La déformation de la couche absorbante supplémentaire 25 provoque également, de manière localisée, une compression locale 29 de la seconde électrode 22b sur la membrane 23. Ceci est, particulièrement, intéressant dans la mesure où cela multiplie les points de contact entre le catalyseur de la seconde électrode 22b et la membrane 23. Cela augmente alors le rendement et les performances globales de la pile à combustible.

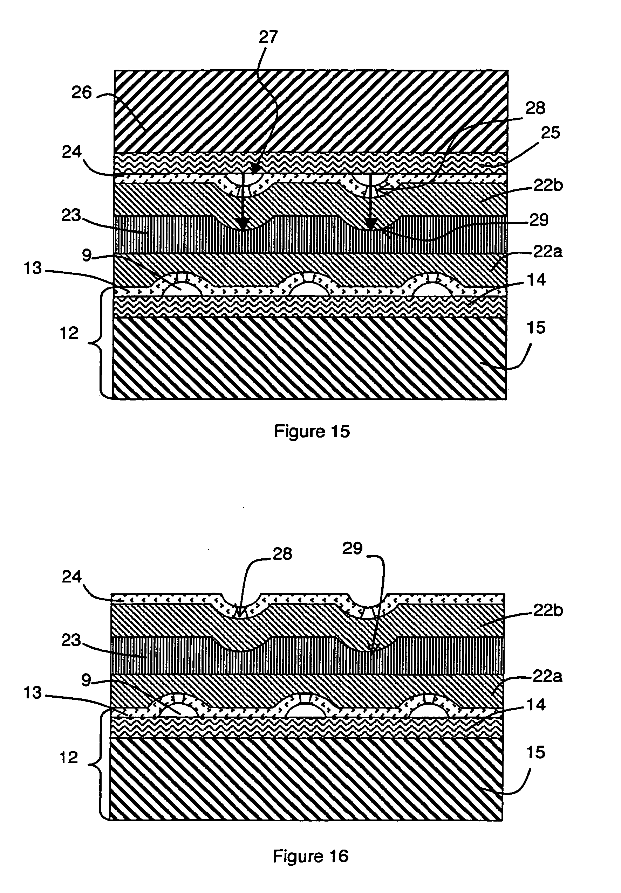

A titre d'exemple, la première électrode 22a peut être une anode, de sorte que la première série de canaux 9 servent de canaux d'alimentation de l'anode en hydrogène. De plus, les couche minces absorbantes 13 et 25 forment les collecteurs de courant de la pile à combustible. Afin d'améliorer leur caractéristique électrique, ces couches absorbantes peuvent être recouvertes d'une couche constituée par un matériau bon conducteur électrique tel qu'un métal noble, par exemple, de l'or. Le substrat 26 et la couche mince supplémentaire 25 peuvent être retirés, par exemple, par dissolution chimique (figure 16). Dans ce cas, la pile à combustible ne comporte qu'une série de canaux d'alimentation 9. Si le substrat 26 et la couche mince supplémentaire 25 ne sont pas retirés, la pile à combustible comportera une deuxième série de canaux d'alimentation en fluide réactif disposés du côté de la seconde électrode 22b.

Une pile à combustible telle que celle représentée à la figure 16 est très compacte, avec une taille de l'ordre de quelques micromètres et avec un rendement beaucoup plus important que celui obtenu avec des piles à combustible selon l'art antérieur.

## Revendications

1. Procédé de fabrication d'au moins un micro-canal (9, 19, 27) enterré sur un substrat (15, 26) **caractérisé en ce qu'**il comporte au moins les étapes successives suivantes :
- la formation, à la surface du substrat (15, 26), d'un empilement d'une couche mince (14, 17, 25) apte à libérer du gaz sous l'action d'un échauffement et d'une couche mince absorbante (13, 18, 24) capable de se déformer localement,
- l'application locale d'un rayonnement optique (10) sur l'empilement de manière à former, à l'interface entre les deux couches minces (14 et 13; 17 et 18; 25 et 24), par échauffement local de la couche mince (14, 17, 25) apte à libérer du gaz, une bulle de gaz déformant la couche mince absorbante (13, 18, 24)
- et le déplacement du rayonnement optique (10) selon une direction prédéterminée de manière à prolonger la déformation de la couche mince absorbante (13, 18, 24) selon ladite direction et former le micro-canal (9, 19, 27) enterré.

2. Procédé selon la revendication 1, **caractérisé en ce que** la couche mince (14, 17, 25) apte à libérer du gaz est en SiCₓO_{y}:H.

3. Procédé selon la revendication 2, **caractérisé en ce que** x est compris entre 0,8 et 1,4 et y est compris entre 1,2 et 1,4.

4. Procédé selon l'une des revendications 2 et 3, **caractérisé en ce que** la couche mince (14, 17, 25) en SiCₓO_{y}:H est obtenue par dépôt chimique en phase vapeur, à l'aide d'un précurseur choisi parmi les organo-silanes.

5. Procédé selon la revendication 4, **caractérisé en ce que** le dépôt chimique en phase vapeur est un dépôt chimique en phase vapeur assisté par plasma.

6. Procédé selon l'une des revendications 4 et 5, **caractérisé en ce que** le précurseur organo-silane est constitué par l'octaméthyltétrasiloxane cyclique ou un de ses dérivés et il est mélangé avec de l'hélium.

7. Procédé selon l'une quelconque des revendications 1 à 6, **caractérisé en ce que** la couche mince (14, 17, 25) apte à libérer du gaz a une épaisseur comprise entre 10nm et 60nm.

8. Procédé selon l'une quelconque des revendications 1 à 7, **caractérisé en ce que** la couche mince absorbante (13, 18, 24) est constituée d'un composé choisi parmi un alliage de tellure et d'étain, un alliage de tellure et de zinc.

9. Procédé selon l'une quelconque des revendications 1 à 8, **caractérisé en ce que** le rayonnement optique est un faisceau laser focalisé.

10. Procédé selon l'une quelconque des revendications 1 à 9, **caractérisé en ce que** le micro-canal (9, 19, 27) a une largeur (L) inférieure à 5µm et une hauteur (H) inférieure a 5µm.

11. Procédé selon l'une quelconque des revendications 1 à 10, **caractérisé en ce qu'**une fois le micro-canal (9, 19, 27) formé, une couche mince de protection (16, 20) est déposée sur une surface libre de la couche mince absorbante (13, 18, 24).

12. Procédé selon l'une quelconque des revendications 1 à 11, **caractérisé en ce que** la formation du micro-canal (9, 19, 27) enterré est suivie d'une étape supplémentaire pendant laquelle un rayonnement optique est appliqué localement sur l'empilement de manière à percer la couche mince absorbante 13 déformée et à former, dans le micro-canal enterré (9, 19, 27), une ouverture (21).

13. Procédé de réalisation d'un micro-dispositif comportant au moins un micro-canal destiné à transporter au moins un fluide **caractérisé en ce que** le micro-canal est un micro-canal enterré sur un substrat mis en oeuvre par le procédé de fabrication selon l'une quelconque des revendications 1 à 12.

14. Procédé selon la revendication 13 **caractérisé en ce que** le micro-canal est destiné à transporter au moins un fluide contenant des éléments chimiques ou biologiques.

15. Procédé selon la revendication 13 **caractérisé en ce que** le micro-dispositif constitue une micro-pile à combustible comportant au moins :
- un empilement constitué par des première et seconde électrodes (22a, 22b) entre lesquelles est disposée une membrane (23) constituée par un polymère conducteur ionique
- et au moins une série de micro-canaux enterrés, destinés à alimenter ladite micro-pile en fluide réactif et munis d'au moins une ouverture (21, 27) pour permettre l'alimentation en fluide réactif.

## Claims

1. Method for producing at least a buried micro-channel (9, 19, 27) on a substrate (15, 26) **characterized in that** it comprises at least the following successive steps:
- formation, on the surface of the substrate (15, 26), of a stacking comprising a thin layer (14, 17, 25) able to release gas due to the action of heating and an absorbent thin layer (13, 18, 24) able to deform locally,
- local application of an optic radiation (10) on the stacking so as to form a gas bubble deforming the absorbent thin layer (13, 18, 24), at the interface between the two thin layers (14 and 13; 17 and 18; 25 and 24), by local heating of the thin layer able to release gas,
- and movement of the optic radiation (10) in a predetermined direction so as to extend the deformation of the absorbent thin layer (13, 18, 24) in said direction and to form the buried micro-channel (9, 19, 27).

2. Method according to claim 1, **characterized in that** the thin layer (14, 17, 25) able to release gas is made of SiCₓO_{y}:H.

3. Method according to claim 2, **characterized in that** x is comprised between 0.8 and 1.4 and y is comprised between 1.2 and 1.4.

4. Method according to one of the claims 2 and 3, **characterized in that** the thin layer (14, 17, 25) made of SiCₓO_{y}:H is obtained by chemical vapor deposition by means of a precursor chosen from the organo-silanes.

5. Method according to claim 4, **characterized in that** the chemical vapor deposition is a plasma enhanced chemical vapor deposition.

6. Method according to one of the claims 4 and 5, **characterized in that** the organo-silane precursor is formed by cyclic octamethyltetrasiloxane or one of its derivatives and that it is mixed with helium.

7. Method according to any one of the claims 1 to 6, **characterized in that** the thin layer (14, 17, 25) able to release gas has a thickness comprised between 10nm and 60nm.

8. Method according to any one of the claims 1 to 7, **characterized in that** the absorbent thin layer (13, 18, 24) is formed by a compound chosen from a tellurium and tin alloy, and a tellurium and zinc alloy.

9. Method according to any one of the claims 1 to 8, **characterized in that** the optic radiation is a focused laser beam.

10. Method according to any one of the claims 1 to 9, **characterized in that** the micro-channel (9, 19, 27) has a width (L) of less than 5µm and a height (H) of less than 5µm.

11. Method according to any one of the claims 1 to 10, **characterized in that** once the micro-channel (9, 19, 27) has been formed, a thin protective layer (16, 20) is deposited on a free surface of the absorbent thin layer (13, 18, 24).

12. Method according to any one of the claims 1 to 11, **characterized in that** formation of the buried micro-channel (9, 19, 27) is followed by an additional step during which an optic radiation is applied locally on the stacking so as to pierce the deformed absorbent thin layer (13) and to form an opening (21) in the buried micro-channel (9, 19, 27).

13. Method for producing a micro-device comprising at least a micro-channel designed to transport at least a fluid, **characterized in that** the micro-channel is a buried micro-channel on a substrate implemented by the method for producing according to any one of the claims 1 to 12.

14. Method according to claim 13, **characterized in that** the micro-channel is designed to transport at least a fluid containing chemical or biological elements.

15. Method according to claim 13, **characterized in that** the micro-device constitutes a micro fuel-cell comprising at least:
- a stacking formed by first and second electrodes (22a, 22b) between which electrodes a membrane (23) formed by an ion conducting polymer is arranged,
- and at least a series of buried micro-channels designed to supply said micro fuel-cell with reactive fluid and provided with at least one opening (21, 27) to enable supply of reactive fluid.

## Patentansprüche

1. Verfahren zur Herstellung von mindestens einen vergrabenen Mikrokanal (9, 19, 27) auf ein Substrat (15, 26), **dadurch gekennzeichnet, dass** es mindestens folgende Schritte umfasst:
- die Bildung einer Aufschichtung aus einer dünnen Schicht (14, 17, 25), die geeignet ist, unter Einwirkung einer Erwärmung Gas freizusetzen, und einer absorbierenden dünnen Schicht (13, 18, 24), die sich lokal verformen kann, auf der Oberfläche des Substrats (15, 26),
- die lokale Anwendung einer optischen Strahlung (10) auf die Aufschichtung, sodass im Übergangsbereich zwischen den beiden dünnen Schichten (14 und 13; 17 und 18; 25 und 24) durch lokale Erwärmung der dünnen Schicht (14, 17, 25), die geeignet ist, Gas freizusetzen, eine Gasblase gebildet wird, die die dünne absorbierende Schicht (13, 18, 24) verformt,
- und das Bewegen der optischen Strahlung (10) in einer vorbestimmten Richtung, um die Verformung der absorbierenden dünnen Schicht (13, 18, 24) in dieser Richtung zu verlängern und den vergrabenen Mikrokanal (9, 19, 27) zu bilden.

2. Verfahren nach Anspruch 1, **dadurch gekennzeichnet, dass** die dünne Schicht (14, 17, 25), die geeignet ist, Gas freizusetzen, aus SiCₓO_{y}:H besteht.

3. Verfahren nach Anspruch 2, **dadurch gekennzeichnet, dass** x in einem Bereich von 0,8 bis 1,4 und y in einem Bereich von 1,2 bis 1,4 liegt.

4. Verfahren nach einem der Ansprüche 2 und 3, **dadurch gekennzeichnet, dass** die dünne Schicht (14, 17, 25) aus SiCₓO_{y}:H durch Gasphasenabscheidung erhalten wird, und zwar mit Hilfe eines Ausgangstoffs, der aus den Organosilanen ausgewählt ist.

5. Verfahren nach Anspruch 4, **dadurch gekennzeichnet, dass** die Gasphasenabscheidung eine plasmaunterstützte CVD ist.

6. Verfahren nach einem der Ansprüche 4 und 5, **dadurch gekennzeichnet, dass** der Organosilan-Ausgangstoff aus zyklischem Oktamethyltetrasiloxan oder einem von dessen Derivaten besteht und mit Helium gemischt ist.

7. Verfahren nach einem der Ansprüche 1 bis 6, **dadurch gekennzeichnet, dass** die dünne Schicht (14, 17, 25), die geeignet ist, Gas freizusetzen, eine Dicke von 10 bis 60 nm hat.

8. Verfahren nach einem der Ansprüche 1 bis 7, **dadurch gekennzeichnet, dass** die absorbierende dünne Schicht (13, 28, 24) aus einer Verbindung besteht, die aus einer Legierung aus Tellur und Zinn und einer Legierung aus Tellur und Zink ausgewählt ist.

9. Verfahren nach einem der Ansprüche 1 bis 8, **dadurch gekennzeichnet, dass** die optische Strahlung ein fokussierter Laserstrahl ist.

10. Verfahren nach einem der Ansprüche 1 bis 9, **dadurch gekennzeichnet, dass** der Mikrokanal (9, 19, 27) eine Breite (L) unter 5 µm und eine Höhe (H) unter 5 µm hat.

11. Verfahren nach einem der Ansprüche 1 bis 10, **dadurch gekennzeichnet, dass** nach der Herstellung des Mikrokanals (9, 19, 27) eine dünne Schutzschicht (16, 20) auf eine freie Fläche der dünnen absorbierenden Schicht (13, 18, 24) aufgebracht wird.

12. Verfahren nach einem der Ansprüche 1 bis 11, **dadurch gekennzeichnet, dass** auf die Herstellung des vergrabenen Mikrokanals (9, 19, 27) ein zusätzlicher Schritt folgt, während dessen örtlich eine optische Strahlung auf die Aufschichtung angewandt wird, um die dünne, verformte absorbierende Schicht (13) zu durchstoßen und in dem vergrabenen Mikrokanal (9, 19, 27) eine Öffnung (21) herzustellen.

13. Verfahren zur Herstellung einer Mikrovorrichtung, die mindestens einen Mikrokanal aufweist, der vorgesehen ist, mindestens ein Fluid zu transportieren, **dadurch gekennzeichnet, dass** der Mikrokanal ein auf einem Substrat vergrabener Mikrokanal ist, der durch das Verfahren nach einem der Ansprüche 1 bis 12 erhalten wurde.

14. Verfahren nach Anspruch 13, **dadurch gekennzeichnet, dass** der Mikrokanal mindestens ein Element transportieren soll, das chemische oder biologische Elemente erhält.

15. Verfahren nach Anspruch 13, **dadurch gekennzeichnet, dass** die Mikrovorrichtung eine Mikrobrennstoffzelle ist, die mindestens umfasst:
- eine Aufschichtung, die aus einer ersten und einer zweiten Elektrode (22a, 22b) besteht, zwischen denen eine Membran (23) angeordnet ist, die aus einem leitenden ionischen Polymer besteht,
- und mindestens eine Reihe vergrabener Mikrokanäle, die dazu bestimmt sind, die Mikrozelle mit reaktivem Fluid zu versorgen und mit mindestens einer Öffnung (21, 27) versehen sind, um die Versorgung mit dem reaktiven Fluid zu ermöglichen.
